# EUROPEAN PATENT APPLICATION

(11) **EP 1 710 593 A2**
(43) Date of publication of application: **11.10.2006**
(21) Application number: 06007297.2
(22) Date of filing: 06.04.2006
(51) Int. Cl.: G01R 31/28

(54) **Process for the preparation and automatic performance of sequence of measurements and tests on an electrical installation**

(30) Priority: 08.04.2005 SI 200500093
(71) Applicant: METREL d.d., 1354 Horjul (SI)
(72) Inventor: Guzelj, Janez, 1356 Dobrova (SI); Gabrovsek, Peter, 1354 Horjul (SI)
(74) Representative: Djukic, Dusan

(57) **Abstract**

A process for preparing and automated performing of measurement and tests on electrical installation that includes advance preparing of arbitrary measurement or arbitrary measuring sequence, adjustment of parameters for particular steps to actual state, that has to be tested with measurements, execution the prepared sequence of measurements and tests, optional simultaneously presenting information about particular step, and optional presenting estimation about measured installation is described.

The process in extended realisation foresees transfer of stored data to personal computer and print report of measurements including the estimation of measured installation and suggestion of suitable fuse.

## Description

### Field of invention

The invention belongs to the field of processes for performing the measurements on electrical installations, as are for example processes for presenting the estimation of electrical installation safety.

### State of technique

The SI 20767 patent (inventors Gabrov 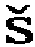 ek and Seliger) deals with the method for automatic measurement of electrical house installation parameters, which enables a sequence of particular measurements, for which the apparatus when running mentioned sequence decides based on measurement of input voltage, enables storing results, sets the limits, compares results but it doesn't have possibility to adjust the length or contents of the method nor selection of influence quantities neither for operator access in case the combination of the measurements in different states of installation.

### Background of invention

Based on standards (e.g. IEC 60364, BS 7671 and others) and / or electrical installation regulations is necessary to measure and test various parameters of electrical installations. Measurer has to establish with the measurements if the installation is properly made out and its characteristics are equal or better than prescripted in regulations.
Through this, it is assured that the electrical installation serves for its purpose and that is safe.
Parameters that has to be measured are e.g. insulation resistance, resistance to earth, resistance to earth connection and equipotential bonding, which are measured with disconnected mains supply; or fault loop and line impedances, tests of protective devices, tracing the phase sequence, which are measured on the installation connected to mains supply.
There are different configurations of electrical installations regarding the ambient, intention and basic protection to electrical surge, with neutral and protective conductors connected through ground (TT), or common protective earth and neutral conductor that is split into two at house installation origin (TN). Complete installation can also be insulated from ground (IT). Another possibility is reduced low voltage with grounded centre star point; in this case, the highest touch voltage is close to conventional safety limit.
Additional influence to the mentioned parameters is required power capacity of tested electrical installation. Electrical installation has to be tested during building, acceptance, repairing and modification. Knowledge, standards and technology developments and to them connected regulations will lead in new times to periodic testing.
This means that for each installation has to be known what to test, the limits and especially that the each verification of electrical installation consists of more measurements that are different. Approval and periodic tests require also test reports with measurement and inspection results.

### Technical problem

Existing processes and methods for the measurement respectively for the verification of electrical installations consist of, at first, with preparative arrangement for required tests and limits definition, and after that the installation is tested in the way that the measurer selects each function from predefined method by using a combined multifunction meter, making test or measurement and verifying and evaluating each result and storing it. Each step is made manually. This procedure is time consuming due to high manual steps count. There is high probability to make error. It happens that measurer even forget to make a measurement, presenting the estimation of tested installation safety is also exposed to errors that the measurer made based on read results.

Measuring report has to be written simultaneously or by recalling of stored results and copying them on paper form or by transferring stored data into computer and this again lead to make mistakes with e.g. arrangement of data.

### Short description of figures

Few figures is attached for easier presentation of description:

| | |
|---|---|
| Figure 1 | Blank base example of sequence tester. |
| Figure 2 | Example of prepared test sequence. |
| Figures 3, 4, 5 | Represents examples of parameters selection for testing according to some of mentioned functions. |
| Figure 6 | Display example for execution of sequence example according to this process. |

### Short description of invention

This invention solves technical problem with the process that makes possible preparing in advance and automated execution of measurements and tests sequence on electrical installations, where the measurer can regarded to measuring problem adjust, modify and upgrade this sequence simultaneously and store it for later usage.
This invention saves test time due to automated run. There is low probability of human made errors because of low manual steps count of the measurer.

### Description of the invention

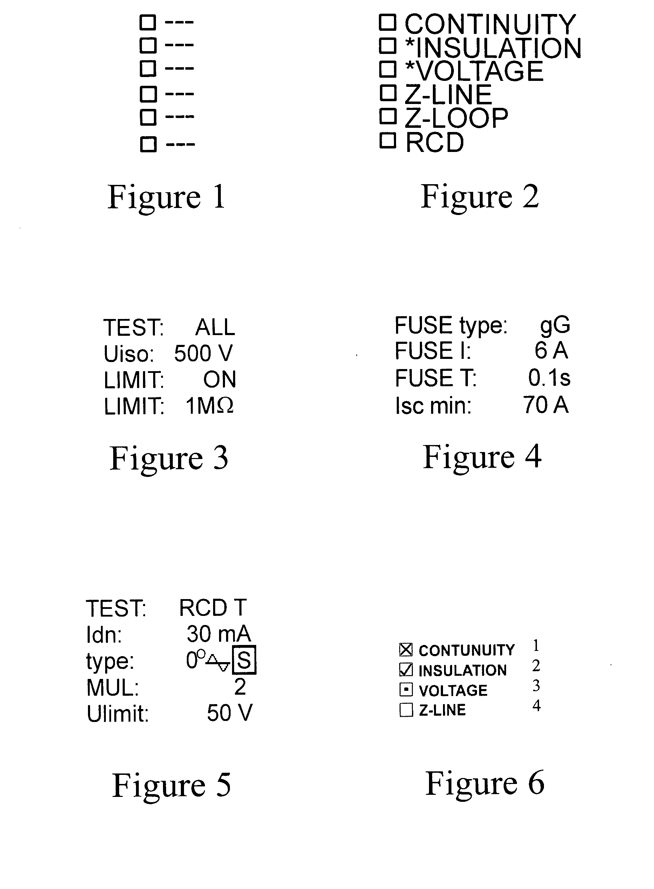

Base of this invention is a sequence of steps that are prepared in advance, where each step (figure 2) represents selected measuring or testing function of free choice from existing set and these steps are performed in prescribed sequence after its start.

The method expects advance preparing and storing of some common test sequences respectively the sequences that will have adjusted parameters to real condition that has to be tested by measurements, before its application.

Figure 1 represents blank field for preparing the sequence of expected measurements. Each line makes possibility to enter selected measurement.
For each step, the one of available functions is selected as is shown on figure 2.
Tests as shown on figure 2 are in each step, which is represented on the figure as particular line, selected from complete set of available functions.

The measurer has usually to make defined intervention before prosecution, e.g. to modify connection on measured place, to turn on or turn off mains supply to installation or to wait for other reason. Measurer will set additional flag for selected test or measurement in this case, figure 2 represents two flagged examples marked with asterisk (*). Selected functions in prepared sequence can also repeat with the same or different parameters.

Only results sometimes are enough when executing the method for selected functions; they can be stored and reviewed, but more important is that the method lightens measurers decision about suitability of tested installation. Parameters for this purpose are not selected only for measurement but also for decision in sense of comparing of measured values with given limits.
Free set-ability makes possibility to modify contents of prepared sequence practically any time except during execution of the measurement of this method.

This means that defined limits are prescribed in most cases. If for example measurement of resistance to earth connection is selected then selected limit presents highest resistance, e.g. 0.3 Ω, which should have the connection from tested socket to main PE collector in fuse board.

Another example is measurement of insulation resistance, with selected test voltage of 500 V according to the system voltage of 230 V, lowest allowed insulation resistance, e.g. 1 MΩ, is required for decision.
A short circuit current from measurements of line and fault loop is that one that is compared with protective devices data. Data of default characteristics of protective devices, those are in the most cases fuses and other types of over current protective devices, also represents parameters that are selected to belonging function, that are selected for preparing sequence according to this method and can be entered into apparatus in the step of adjusting parameters according to real state.
The similar are for RCD defined regularity of disconnection, sensitivity and permitted touch voltage.

Results of particular functions decide to final test result. This means that all good results of particular functions, with enabled comparison, represent common measure for presumption of good installation.

Simultaneously information about improper measurement result (figure 6, line 1), about suitable measurement result (figure 6, line 2), just information about performed measurement (figure 6, line 3) or that the measurement is not performed respectively is in progress (figure 6, line 4), can be received during execution of the sequence of the method.

Advantages of the method of subjected invention:
- a possibility for preparing sequences in advance and store them in memory medias,
- simple preparing the sequences of tests,
- selection of arbitrary measurement sequence on measured place,
- makes possibility to use a list of fuses with their characteristics,
- 100 % repeatability of the methods,
- simultaneous adjustment of parameters regarding to default requirements for tested electrical installation,
- shorter time of measurements execution in comparison with known methods,
- less human error possibility in comparison with known methods.

### Example 1

### Description of measuring course for typical safety test according to known method

Known methods are mainly coursing step by step, that means, that one measurement is evaluated by measurer after it is finished, and after that the next measurement is selected.
This requires high knowledge of measurer and skill for permitted limits of measured values.
The method is coursed in the following groups of steps:

Connection of the apparatus to wall socket, checking voltages on conductors L/N/PE (line/neutral/protect earth), and this requires three times of connection to socket and detection of installation type (TT, TN or IT).
After that the impedance of supply loop Z_{LINE} is measured, and later the measurement of fault loop impedance Z_{LOOP} is applied.
For each step, it is necessary to select the measurement manually with switches on the measuring apparatus, to read results after finished measurement and to store and evaluate them if needed.
At the end of complete procedure, it is necessary to make evaluation from particular results of measured installation as "pass" or "fail".

It is necessary to realize 14 manual operations during execution of method described above and it takes about 30 s for skilled measurer.
It is required to accent that the described method is referred to only one wall socket, i.e. measurement of only one circuit.

### Example 2

### (realization example)

### Description of measuring course for typical safety test according to new automated method.

The method that is subject of this invention has course in the following steps:

Connection of apparatus to wall socket and selection of pre-programmed measuring sequence, e.g. using keys on the apparatus.
By pressing the only one key, the measurer starts performing of measuring sequence, namely the first verification of voltage on conductors L/N/PE, then detecting type of electrical installation (TT, TN, or IT), measurement of line impedance Z_{LINE}, and measurement of fault loop impedance Z_{LOOP}.

Optional evaluation presenting of measured installation as "PASS" or "FAIL" is expected at the end of complete method, based on comparing results of particular measurements with permissible values that are stored in the memory of apparatus, and adequacy evaluation of fuse that was selected from fuse list stored in the memory of the apparatus. Based on measurement, it could also offer suggestion of appropriate fusses from mentioned list.

After finished measurement, the measurer has just to press a key for storing results, to store results of all measurements, which were executed according to selected sequence, including all good/bad estimations. The measurer takes suitable measures (searching the reason for unsuitability of installation respectively verify and replace fuse if necessary) based on offered estimation of measured electrical installation suitability (and suggestion of appropriate fuse).

It is necessary to do maximum 5 manual operations during course of described automated method, it takes approximately 11 s for execution of described method for skilled measurer.

If existing method of performed measurements as described in example 1 and automated method of performed measurements as described in example 2 are compared, then it can be seen that the measuring time is approximately three times shorter, and also the number of required manual operations is three times lower.

According the method that is subject of this invention, the measurements are performed faster and essentially more reliable because the possibility of human error is essentially reduced.

The possibility of preparing measuring methods in advance enables preparing for measurements of demanding systems in domestic ambient, e.g. in the office or in the workroom. Through this, there is practically rejected possibility to forget particular measurement.
In the field, at measuring place, is just needed to select prepared sequence method, to adjust particular test or measurement parameters if necessary, to execute selected sequence and to store common result.
Stored results can be transferred to a personal computer, where can be edited and printed in measuring report form.
Method of preparing and automated executing the sequence of measurements and tests on electrical installations is described, but it is in no way limited to the description above and also includes all evident derivatives of described method. A range of required protection is defined in claims.

## Claims

1. Process for the preparation and automated performing of measurements and tests on electrical installations **characterised in that** it includes following steps:
- preparing of arbitrary measurement or arbitrary measuring sequence in advance,
- adjusting parameters of particular steps to actual state that has to be tested with measurements,
- performing the prepared sequence of measurements and tests,
- optional simultaneously presenting information of particular step,
- optional presenting estimation about measured installation.

2. Process for the preparation and automated performing of measurements and tests on electrical installations **characterised in that** it includes following steps:
- preparing of arbitrary measurement or arbitrary measuring sequence in advance,
- adjusting parameters of particular steps to actual state that has to be tested with measurements,
- performing the prepared sequence of measurements and tests,
- optional simultaneously presenting information of particular step,
- storing results of measurements in memory of apparatus,
- optional presenting estimation about measured installation,
- transferring of stored data to personal computer,
- printing report of measurements including estimation of measured installation and suggestion of suitable fuse.

3. Process according the claims 1 or 2 **characterised in that** the mentioned step for advance preparation of arbitrary measurement or arbitrary measuring sequence also includes a step for storing of prepared mentioned measurement or measuring sequence in arbitrary medium.

4. Process according the claims 1, 2 or 3 **characterised in that** the mentioned step for advance preparation of arbitrary measurement or arbitrary measuring sequence enables marking of particular measurement **in that** way that method waits to the next command of operator, with which the intermediate intervention is enabled for the operator to measurement and/or measured installation.

5. Process according to any previous claim **characterised in that** the mentioned step of parameters adjustment for particular steps to the actual status, that has to be tested with measurements, includes entering the permissible limits of measured parameters regarding the measured installation and optionally data of default characteristics of protection devices, as are for example fuses or other types of over current protection devices.
